(19) Europäisches Patentamt

European Patent Office

Office européen des brevets

(11) **EP 4 749 300 A1**

(12) **EUROPEAN PATENT APPLICATION**

(43) Date of publication:
27.05.2026 Bulletin 2026/22

(21) Application number: 24214685.0

(22) Date of filing: **22.11.2024**

(51) International Patent Classification (IPC):
*G01R 31/08* (2020.01)    *H02H 9/08* (2006.01)

(52) Cooperative Patent Classification (CPC):
**H02H 9/08;** G01R 31/086

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(71) Applicant: **ABB SCHWEIZ AG**
**5400 Baden (CH)**

(72) Inventors:
• **Siermala, Saku**
**65320 Vaasa (FI)**
• **Leminen, Janne**
**33720 Tampere (FI)**
• **Altonen, Janne**
**33720 Tampere (FI)**

(74) Representative: **Kolster Oy Ab**
**Salmisaarenaukio 1**
**P.O. Box 204**
**00181 Helsinki (FI)**

(54) **METHOD AND APPARATUS FOR CONTROLLING ARC SUPPRESSION DEVICE**

(57)    A method and apparatus for controlling an arc suppression device of a three-phase electric network, the arc suppression device having an adjustable admittance connected between a neutral point of the three-phase electric network and earth, the apparatus being configured to determine (110) a resonant frequency of a zero-sequence system of the three-phase electric network and determine (120), based on the determined resonant frequency of the zero-sequence system of the three-phase electric network, whether to initiate a tuning of the arc suppression device of the three-phase electric network.

Fig. 4

**Description**

TECHNICAL FIELD

The present invention relates to a method and an apparatus for controlling an arc suppression device.

BACKGROUND

An arc suppression device can be used for compensating a fault current caused by a single-phase-to-earth fault. An example of the arc suppression device is an Arc Suppression Coil, ASC, which is a passive inductive device that is connected between a neutral point of an electric system (e.g. network) and earth to limit the capacitive earth-fault current flowing, when a single-phase-to-earth fault occurs in the system. The ASC was originally developed by Waldemar Petersen and is therefore sometimes referred to as the Petersen Coil. This kind of system earthing method may be called as the resonant earthing. The resonant earthing is a commonly used earthing practice in medium voltage networks, for example, and it has been used in several countries for many decades with good operational experiences. An example of the ASC is disclosed in US 1537371. An electric network provided with one or more such arc suppression devices may be referred to as a compensated network.

The idea of the resonant earthing may be generally to match, either essentially completely or at least partially, an admittance of the arc suppression device(s) to the total phase-to-earth capacitance formed by the network conductors. In this case the magnitude of the earth-fault current at the fault location can be limited below the level of self-extinguishment, which can suppress transient earth faults without a feeder tripping, for example. Also, the touch and hazard voltages can be limited with the decreased fault current value, which also can limit the danger to public and property, and improve safety to personnel, for instance.

In order to set the admittance value of the arc suppression device(s) to match the total phase-to-earth capacitance of the network conductors, at least an inductance, provided by e.g. one or more adjustable coils, of the arc suppression device may be variable and a controller device (e.g. a coil controller) can be used. The purpose of such a controller device is to adjust, i.e. tune, the arc suppression device admittance to match, either essentially completely or at least partially, the total phase-to-earth capacitance value of the network. And if the phase-to-earth capacitance value of the network changes, the controller device may again adjust (tune) the admittance of the arc suppression device(s) to match the changed phase-to-earth capacitance value of the network.

When changes in the compensated network occur, the size of the galvanically connected network may change. As the lines of the network have a specific line-to-earth capacitance per kilometer, the total line-to-earth capacitance of the network may vary depending on the network topology, for example. Therefore, the tuning of the arc suppression device(s) should preferably correspond to the prevailing network topology, which means that e.g. after a change in the network topology, the arc suppression device(s) may have to be tuned (or retuned). It is therefore preferable to automatically and reliably detect changes in the network configuration or generally changes in the tuning of the arc suppression device(s) so that it can be determined if the (re)tuning of the arc suppression device of the electric network should be initiated (triggered) in order to determine a new tuning point for the arc suppression device(s).

One way to determine whether to initiate the tuning of the arc suppression device of the three-phase electric network may be based on monitoring changes in the (absolute or phasor) value of the zero-sequence voltage of the network which indicate changes in the network. However, to reliably detect changes in the zero-sequence voltage, a sufficient level of natural zero-sequence voltage should be present in the network. This may set a limit for allowed symmetry of the network, for instance. For example, when a symmetrical line section is switched on in the network, there may be essentially no sufficient change in the zero-sequence voltage of the network and such a change in the switching state or the network configuration may not be detected by such monitoring of the zero-sequence voltage of the network, for example. Moreover, rapid changes in the zero-sequence voltage can also occur without changes in the network configuration due to strong load current fluctuations, capacitively coupled signals and/or due to short-term fluctuations in the network frequency, for example, which may lead to unreliable detection of changes in the network configuration.

BRIEF DESCRIPTION

An object of the present invention is thus to provide a method and an apparatus for implementing the method so as to overcome the above problem or at least to alleviate the above problem. The object of the invention is achieved by a method and an apparatus which are characterized by what is stated in the independent claims. The preferred embodiments of the invention are disclosed in the dependent claims.

The invention is based on the idea of determining a resonant frequency of a zero-sequence system of the three-phase electric network and determining, based on the determined resonant frequency of the zero-sequence system of the three-phase electric network, whether to initiate a tuning of the arc suppression device of the three-phase electric network.

An advantage of the solution of the invention is that it is robust and applicable also in connection with symmetrical networks or portions thereof for determining whether to initiate the tuning of the arc suppression device of the three-phase electric network.

BRIEF DESCRIPTION OF THE DRAWINGS

In the following the invention will be described in greater detail by means of preferred embodiments with reference to the accompanying drawings, in which

Figure 1 is an example of a three-phase electric network illustrating an embodiment;
Figure 2 is an example of a three-phase electric network illustrating an embodiment;
Figure 3 illustrates a diagram according to an embodiment;
Figure 4 illustrates a flow diagram according to an embodiment; and
Figure 5 illustrates a block diagram according to an embodiment.

DETAILED DESCRIPTION

The following embodiments are exemplary. Although the description may refer to "an", "one", or "some" embodiment(s) in several locations, this does not necessarily mean that each such reference is to the same embodiment(s), or that the feature only applies to a single embodiment, for example. Single features of different embodiments may also be combined to provide other embodiments. Generally, all terms and expressions used should be interpreted broadly and they are intended to illustrate, not to restrict, the embodiments. The figures only show components necessary for understanding the various embodiments. The number and/or configuration of the various elements, and generally their implementation, could vary from the examples shown in the figures.

Different embodiments and examples may be described below using single units, models, equipment and memory, for example, without restricting the embodiments/examples to such a solution. Concepts called cloud computing and/or virtualization may be used. The virtualization may allow a single physical computing device to host one or more instances of virtual machines that appear and operate as independent computing devices, so that a single physical computing device can create, maintain, delete, or otherwise manage virtual machines in a dynamic manner. It is also possible that device operations will be distributed among a plurality of servers, nodes, devices or hosts. In possible cloud computing network devices, computing devices and/or storage devices may provide shared resources. Some other technology advancements, such as Software-Defined Networking (SDN), may cause one or more of the functionalities described below to be migrated to any corresponding abstraction or apparatus or device. Therefore, all words and expressions should be interpreted broadly, and they are intended to illustrate, not to restrict, the embodiment in question.

The application of the various embodiments described herein is not limited to any specific system, but it can be used in connection with various three-phase electric networks with a compensated neutral, also known as resonant-earthed networks, where compensation of fault current is achieved by installing one or more arc suppression devices, such as Arc Suppression Coils (ASC), also known as Petersen coils or compensation coils, into neutral point(s) (star point, zero point) of the system. The electric network, in which the various embodiments may be implemented, can be an electric power transmission and/or distribution network or a portion or a component of a larger network, for example, and may comprise several electric lines and/or sections. The electric network may have a radial configuration supplied from one point thereof or a loop configuration comprising one or more loops and supplied from two or more points, or a combination of such configurations, for instance. Moreover, the use of the various embodiments is not limited to systems employing 50 Hz or 60 Hz fundamental frequencies or to any specific voltage level. Also a phase rotation order, such as L1-L2-L3 or L1-L3-L2, of the system does not limit the use of the various embodiments.

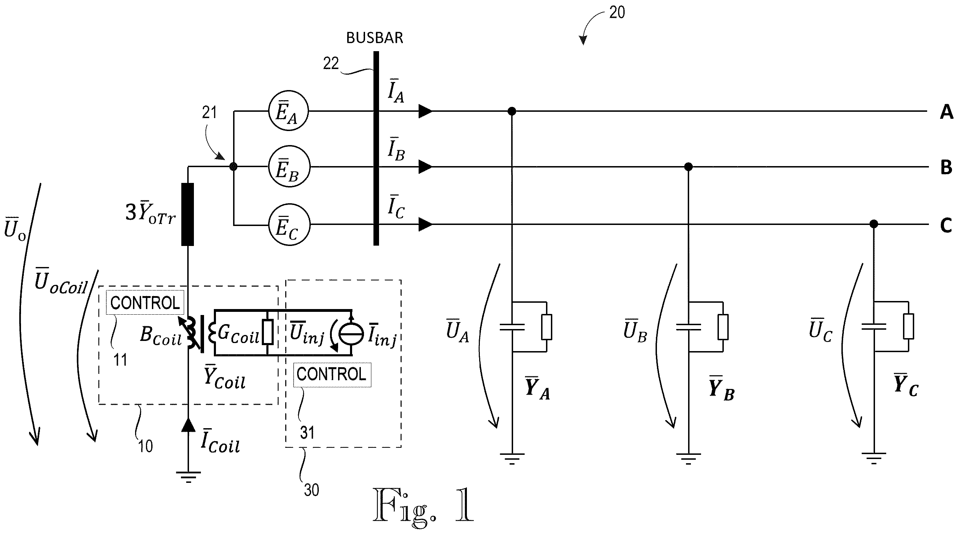

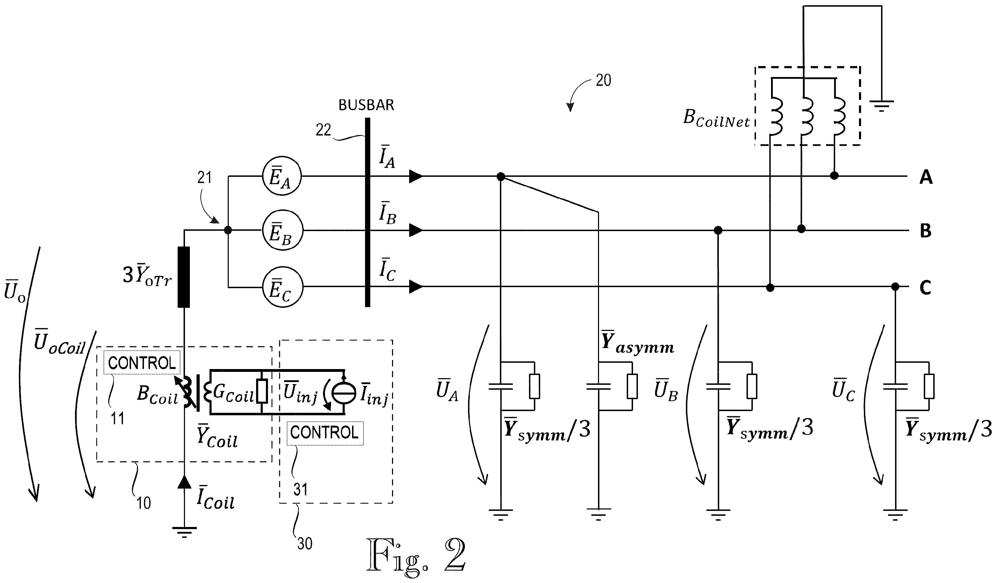

Figures 1 and 2 are simplified diagrams of an exemplary electric system (network) showing some equipment (e.g. apparatuses, devices, nodes) and functional entities, whose implementation and/or number and/or configuration may differ from what is shown in the examples of Figures 1 and 2. Such a system may also comprise other equipment, functional entities and/or structures, some of which used in or for big data, data management, and communication in the system or in any part of the system, for example. Also e.g. any communications protocols used may vary and may depend on the system characteristics, for instance. Figures 1 and 2 are diagrams illustrating simplified equivalent circuits of a three-phase electric network in which the various embodiments can be applied. The exemplary three-phase network with phases A, B and C may be a medium voltage (e.g. 20 kV) distribution network fed through a substation comprising a source $\overline{E}_A, \overline{E}_B, \overline{E}_C$, such as a transformer or generally a feeding point of the electric network, and a feeding busbar 22 connected to one or more electric line outlets (feeders) 20, for example. Respective phase currents of phases A, B and C are $\overline{I}_A, \overline{I}_B$, and $\overline{I}_C$, with a positive current direction from the feeding point towards line as indicated by the arrows in the figure, and respective phase voltages are $\overline{U}_A, \overline{U}_B$, and $\overline{U}_C$. Figures 1 and 2 further illustrate an arc suppression device (apparatus, equipment) 10, which is connected between a neutral point (star point, zero point) 21 of the three-phase electric network and earth. The arc suppression device 10 may be the only arc suppression device in the electric network or it may be a central arc suppression device, and the electric network may further comprise distributed compensation, i.e. one or more additional arc suppression devices distributed along the one or more electric line outlets (feeders) 20 and/or one or more additional arc suppression devices (not shown in the figures) located at the substation, for example. The arc suppression device 10 can be connected to the neutral point 21 of the electric network via an earthing transformer or any other suitable arrangement, for example. An admittance of the arc suppression device 10 is $\overline{Y}_{Coil}$ and the exemplary arc suppression device 10 as illustrated may comprise at least one adjustable coil. The arc suppression device 10 could comprise more than one adjustable and/or non-adjustable coil, for instance. $\overline{I}_{Coil}$ is the current flowing through the arc suppression device 10. The arc suppression device 10 may further include a controller for controlling, e.g. tuning, the adjustable coil, and also for generally controlling any functionality of the arc suppression device 10, for instance. Figures 1 and 2 further illustrate a current injection device (apparatus, equipment) 30, which is connected in parallel to the arc suppression device 10. The current injection device 30 may be a separate device or entity, possibly in a separate housing, or the current injection device 30 may be an integrated part of the arc suppression device 10, such as a module thereof, for example.

Current and voltage values used in the various embodiments described herein may be obtained by a suitable measuring arrangement, which may include current and/or voltage transducers (not shown in the figures) connected to the phases of the electric network or similar equipment, for example. Voltage and current quantities may also be measured at different locations, for instance. In existing electric networks and systems, such values are typically readily available and thus the implementation of the various embodiments does not necessarily require any separate or additional measuring arrangements. It should be noted that e.g. admittance, conductance, and/or susceptance could be used in any calculations and definitions disclosed herein in an analogous manner instead of impedance, resistance, and/or reactance, and vice versa, for example.

The figures also show a (first) control arrangement 11, such as a controller device or a control unit of the arc suppression device 10, located within the arc suppression device 10. Such a control arrangement 11 could also be located outside the arc suppression device 10 and could be configured to control more than one arc suppression devices 10, for example. In the exemplary systems of Figures 1 and 2, at least part of the functionality of the various embodiments may be located in the control arrangement 11, for example. The control arrangement 11 may be configured to receive necessary measurement data and/or perform at least some measurements by itself, and to control, i.e. tune, the adjustable coil of the arc suppression device 10. The figures further show a (second) control arrangement 31, such as a controller device or a control unit of the current injection device 30, located within the current injection device 30. Such a control arrangement 31 could also be located outside the current injection device 30. Such a control arrangement 31 could be a separate entity as illustrated in the examples or integrated with the control arrangement 11 of the arc suppression device 10, for example. In the exemplary systems of Figures 1 and 2, at least part of the functionality of the various embodiments may be provided by means of the control arrangement 31 of the current injection device 30, for example. It is thus possible that the functionalities of the first control arrangement 11 and the second control arrangement 31 are combined into one control arrangement which may thus control the operation of both the arc suppression devices 10 and the current injection device 30, for instance, and may implement at least part of the functionality of the various embodiments disclosed herein.

The following notation is used in Figure 1 (overbar denotes a complex quantity):

$\overline{E}_A$ is the phase A to neutral voltage of the source
$\overline{E}_B$ *is the phase B to neutral voltage of the source*
$\overline{E}_C$ is the phase C to neutral voltage of the
$\overline{U}_A$ is the phase A to earth voltage at busbar
$\overline{U}_B$ is the phase B to earth voltage at busbar
$\overline{U}_C$ is the phase C to earth voltage at busbar
$\overline{U}_o$ is the neutral point voltage (the zero-sequence voltage) of the electric network, which can be measured e.g. at the busbar or at the source
$\overline{I}_{inj}$ is the injected current
$\overline{U}_{inj}$ is the output voltage of the current injection device
$\overline{U}_{oCoil}$ is the voltage over the arc suppression device
$\overline{I}_A$ *is the phase A current at the source*
$\overline{I}_B$ *is the phase B current at the source*
$\overline{I}_C$ is the phase C current at the source
$\overline{I}_{Coil}$ is the current through the arc suppression device
$\overline{Y}_A$ is the phase A to earth admittance of the electric network (excluding the arc suppression device 10)
$\overline{Y}_B$ is the phase B to earth admittance of the electric network (excluding the arc suppression device 10)
$\overline{Y}_C$ is the phase C to earth admittance of the electric network (excluding the arc suppression device 10)
$\overline{Y}_{oTr}$ is the zero-sequence admittance per phase of an earthing transformer or a main transformer, or another arrangement, which is used to form the neutral point of the electric network and through which the arc suppression device is connected to the electric network.

$\overline{Y}_{Coil} = G_{Coil} + j \cdot B_{Coil}$ is the admittance of the arc suppression device

j is the imaginary unit also known as a complex operator

$G_{Coil}$ is the conductance of the arc suppression device corresponding to the parallel resistor and the natural losses of the coil

$B_{Coil}$ is the susceptance of the arc suppression device

The notation used in Figure 2 corresponds to that of Figure 1 except that in Figure 2 the inductive susceptance of the electric network due to possible distributed arc suppression device(s) $B_{CoilNet}$ is shown separately and the individual phase admittances of the electric line outlets 20 are presented with symmetrical phase admittances, whose sum equals the symmetrical network admittance:

$$\overline{Y}_{symm} = G_{symm} + j \cdot B_{symm}$$

(one third in each phase)

Parameter $G_{symm}$ is the real part of the symmetrical network admittance. The sign is positive and it represents the shunt losses of the electric network (excluding the losses of the arc suppression device). Parameter $B_{symm}$ is the imaginary part of the symmetrical network admittance. The sign is positive (capacitive) and it represents the capacitive uncompensated earth-fault current of the electric network.

The natural asymmetry present in a real system is due to differences in individual phase admittances and it has thus in practice an arbitrary value. In Figure 2 it is presented with an asymmetry admittance concentrated into phase A and presented with the asymmetry admittance:

$$\overline{Y}_{asymm} = G_{asymm} + j \cdot B_{asymm}$$

(only in phase A in the example)

The asymmetry admittance $\overline{Y}_{asymn} = G_{asymm} + j \cdot B_{asymm}$ represents the asymmetry of the phase-to-earth admittances of the electric network reduced to a lumped admittance in phase A. Parameter $G_{asymm}$ is the real part of asymmetry admittance. The sign may be positive or negative depending on the actual level of asymmetry. Parameter $B_{asymm}$ is the imaginary part of asymmetry admittance. The sign may be positive or negative depending on the actual level of asymmetry i.e. on the differences between the actual phase to earth admittances of the electric network.

The asymmetry admittance may also be calculated from phase-wise admittances as follows:

$$\overline{Y}_{asymm} = \overline{Y}_A + \overline{a}^2 \cdot \overline{Y}_B + \overline{a} \cdot \overline{Y}_C$$

The symmetry admittance is then solved from the total admittance of the electric line outlets $\overline{Y}_{Net}$ as follows:

$$\overline{Y}_{symm} = \overline{Y}_{Net} - \overline{Y}_{asymm} = \overline{Y}_A + \overline{Y}_B + \overline{Y}_C - \overline{Y}_{asymm}$$

In the example of Figure 2 the following applies:

$$\overline{Y}_A = \frac{\overline{Y}_{symm}}{3} + \overline{Y}_{asymm} - j\frac{B_{CoilNet}}{3}$$

$$\overline{Y}_B = \frac{\overline{Y}_{symm}}{3} - j\frac{B_{CoilNet}}{3}$$

$$\overline{Y}_C = \frac{\overline{Y}_{symm}}{3} - j\frac{B_{CoilNet}}{3}$$

The theoretical basis of the embodiments disclosed herein lies in the idea that at a tuned state the resonant frequency of the zero-sequence system of the electric network assumes a set value according to a set detuning degree, and any deviation in the detuning also shows as a change in the resonant frequency, for example. Consequently, the resonant frequency of the electric network's zero-sequence system can be used as a monitored parameter for detecting a network switching operation or change in the detuning or generally a change in the electric network configuration. Term zero-sequence system (zero-sequence network) herein generally refers to one of the three component systems (networks) as defined by the well-known theory of symmetrical components, the other two being the positive-sequence system and the negative-sequence system. According to an embodiment, the system's resonant frequency can be determined by means of current injection as described in more detail below. The injection current can be supplied to the electric network by any known method, e.g., into the power auxiliary windings of the arc suppression device.

As the resonant frequency is dependent on the detuning of the zero-sequence system of the electric network, the disclosed solution may essentially only detect changes in the detuning and not in the damping, which can be beneficial e.g. for applications that only monitors changes in the detuning, e.g. if used to trigger tuning procedure of the arc suppression device. The disclosed solution is applicable e.g. to symmetrical networks and robust against network frequency disturbances, high load changes etc. The time required for determining the resonant frequency as disclosed below, may depend on e.g. the desired precision of the resonant frequency determination. The resonant frequency of the zero-sequence system of the electric network can be described by the following equation:

$$f_{res} = \frac{1}{2\pi\sqrt{\frac{L_{Coil} \cdot L_{Net}}{L_{Coil} + L_{Net}} C_{Net}}} = \frac{1}{2\pi\sqrt{L_{Tot}C_{Tot}}} = f_s\sqrt{\frac{I_{Ltot}}{I_{Ctot}}}$$

where:

$L_{Coil}$ is the inductance of the arc suppression device

$C_{Net}$ is the zero-sequence capacitance of the electric network excluding the arc suppression device 10

$L_{net}$ is the zero-sequence inductance of the electric network due to distributed arc suppression device(s)

$L_{Tot}$ is the total zero-sequence inductance of the electric network (including the arc suppression device 10). In this case, $L_{Tot} = \frac{L_{Coil} \cdot L_{Net}}{L_{Coil} + L_{Net}}$

$C_{Tot}$ is the total zero-sequence capacitance of the electric network (including the arc suppression device 10). In this case, $C_{Tot} = C_{Net}$.

$f_s$ is the synchronous frequency of the three-phase electric network, e.g. 50Hz. Alternatively, $f_s$ can also be a measured network frequency, for example.

$I_{Ctot}$ is the total capacitive earth fault current at $f_s$ of the electric network

$I_{Ltot}$ is the total inductive earth fault current produced by the arc suppression device 10 and any distributed arc suppression device(s) at $f_s$ of the electric network

It can be concluded that the resonant frequency is dependent on the ratio of inductive to capacitive earth fault current. Table 1 shows some examples of the effect of a change (#1 -> #2) in the ratio of the inductive to capacitive earth fault current on the resonant frequency of the zero-sequence system in an exemplary network.

Table 1

|  |  | #1 | #2 | Change (#1 → #2) |
|---|---|---|---|---|
| 10 % increase in ratio of $I_{Ltot}/I_{Ctot}$ | $I_{Ltot}/I_{Ctot}$ | 1 | 1.1 | 10% |
|  | $f_{res}$ | 50 Hz | 52.4 Hz | ~2.5 Hz |
| 20 % increase in ratio of $I_{Ltot}/I_{Ctot}$ | $I_{Ltot}/I_{Ctot}$ | 1 | 1.2 | 20% |
|  | $f_{res}$ | 50 Hz | 54.7 Hz | ~5 Hz |
| 30 % increase in ratio of $I_{Ltot}/I_{Ctot}$ | $I_{Ltot}/I_{Ctot}$ | 1 | 1.3 | 30% |
|  | $f_{res}$ | 50 Hz | 57.0 Hz | ~7 Hz |
| 100 % increase in ratio of $I_{Ltot}/I_{Ctot}$ | $I_{Ltot}/I_{Ctot}$ | 1 | 2 | 100 % |
|  | $f_{res}$ | 50 Hz | 70.7 Hz | ~20 Hz |

(continued)

| | | #1 | #2 | Change (#1 → #2) |
|---|---|---|---|---|
| 300 % increase in ratio of $I_{Ltot}/I_{Ctot}$ | $I_{Ltot}/I_{Ctot}$ | 1 | 4 | 300 % |
| | $f_{res}$ | 50 Hz | 100 Hz | ~50 Hz |

Table 2 shows some examples of the effect of a change (#1 -> #5) in the resonant frequency of the zero-sequence system due to changes in the detuning (or in the electric network topology) in three different size category (small, medium, large) networks.

Table 2

| Category | Small | | | Medium | | | Large | | |
|---|---|---|---|---|---|---|---|---|---|
| Network topology | $I_{Ltot}$ = 50 A | | | $I_{Ltot}$ = 150 A | | | $I_{Ltot}$ = 600 A | | |
| | $I_{Ctot}$ [A] | $I_{Ltot}/I_{Ctot}$ | $f_{res}$ [Hz] | $I_{Ctot}$ [A] | $I_{Ltot}/I_{Ctot}$ | $f_{res}$ [Hz] | $I_{Ctot}$ [A] | $I_{Ltot}/I_{Ctot}$ | $f_{res}$ [Hzl] |
| #1 (resonance) | 50 | 1 | 50 | 150 | 1 | 50 | 600 | 1 | 50 |
| #2 | 45 | 1.11 | 52.7 | 135 | 1.11 | 52.7 | 540 | 1.11 | 52.7 |
| # 3 | 40 | 1.25 | 55.9 | 120 | 1.25 | 55.9 | 480 | 1.25 | 55.9 |
| #4 | 25 | 2 | 70.7 | 75 | 2 | 70.7 | 300 | 2 | 70.7 |
| #5 | 10 | 5 | 112 | 30 | 5 | 112 | 120 | 5 | 112 |

According to an embodiment, a method for controlling an arc suppression device of a three-phase electric network is provided, wherein the arc suppression device has an adjustable admittance connected between a neutral point of the three-phase electric network and earth. According to an embodiment, the method comprises: a) determining a resonant frequency of a zero-sequence system of the three-phase electric network, and b) determining, based on the determined resonant frequency of the zero-sequence system of the three-phase electric network, whether to initiate a tuning of the arc suppression device of the three-phase electric network. According to an embodiment, steps a) to b) may be repeated essentially continuously or at predetermined intervals.

According to an embodiment, the determining of the resonant frequency of the zero-sequence system of the three-phase electric network may comprise sequentially injecting current signals of varying frequency or frequencies into the neutral point of the three-phase electric network, monitoring a response in the three-phase electric network to the sequential injection of the current signals and determining the resonant frequency of the zero-sequence system of the three-phase electric network on the basis of the monitored response in the three-phase electric network to the sequential injection of the current signals. According to an embodiment, the sequential injection of the current signals is performed as a frequency sweep, wherein the frequency or frequencies of the sequentially injected current signals are varied between a predetermined minimum frequency $f_{min}$ and a predetermined maximum frequency $f_{max}$. According to an embodiment, the frequency or frequencies of the sequentially injected current signals may be varied between the predetermined minimum frequency and the predetermined maximum frequency in an increasing manner starting from the predetermined minimum frequency or in a decreasing manner starting from the predetermined maximum frequency. According to an embodiment, the frequency or frequencies of the sequentially injected current signals are varied in a continuous manner or in a discrete manner. Accordingly, the determining of the resonant frequency of the zero-sequence system of the three-phase electric network may include performing the determination of the zero-sequence system resonant frequency with a sufficient accuracy, preferably with a precision that is from fractions of a hertz to a few hertz, for example. According to an embodiment, to accurately determine the resonant frequency, a frequency sweep method may be used, wherein e.g. a sinusoidal current signal is injected with a varying frequency continuously or discretely from $f_{min}$ to $f_{max}$, preferably with a predetermined frequency step $f_{step}$ and time per frequency $t_{step}$, e.g., from few hundred of milliseconds to seconds. According to an embodiment, the injection sequence used for determining the resonant frequency can further be optimized with multiple, i.e. two or more, frequency sweeps with different settings: $f_{min}$, $f_{max}$, $f_{step}$ and $t_{step}$ and each iteration sweep can be adjusted based on the results of the previous sweep so that the method converges and locates the resonant frequency accurately with the least amount time and least number of injected frequencies, for example. The current injection signal may have the following sinusoidal form:

$$I'_{inj}(t, f_i, \theta) = \hat{I}'_{inj} sin(2\pi f_i t + \theta), \qquad f_i \in [f_{min}, f_{max}], \theta \in [0, 2\pi]$$

where:

$\hat{I}'_{inj}$ is the peak amplitude value of the current signal reduced to primary voltage level, e.g., $\hat{I}'_{inj} = \sqrt{2}\left|\overline{I}'_{inj}\right|$

t is the time in seconds.

According to an embodiment, the amplitude of the signal $\left|\overline{I}'_{inj}\right|$ (in phasor domain/rms value) in primary voltage level can be selected e.g. by considering the zero-sequence voltage response target $\overline{U}_{0\_target}$, when the electric network damping $I_d$ is known or can be estimated:

$$\left|\overline{I}'_{inj}\right| = \frac{\left|\overline{U}_{0\_target}\right|}{U_{PE}} I_d$$

where: $|\overline{U}_{p\text{-}target}|$ is the highest possible voltage response for current injection with amplitude $\left|\overline{I}'_{inj}\right|$. Also, the maximum allowed injection current level can be calculated using the previous equation.

According to an embodiment, the resonant frequency can then be determined on the basis of the monitored response in the three-phase electric network to the sequential injection of the current signals. According to an embodiment, the resonant frequency can be determined to be the frequency for which the highest or maximum, or generally most significant, response of electrical system is achieved or observed. For example, the frequency at which the electric network zero sequence impedance/admittance is in resonance. Such a highest or maximum, or generally most significant, response of the electrical system may be detected in response to a predetermined parameter or quantity of the three-phase electric network reaching its highest (maximum) or lowest (minimum) value, for example. This may be determined e.g. according to any one of the following conditions or any combination thereof:

1. Highest effective zero-sequence voltage value: $\max|\overline{U}_0(f_i)|$ (constant injection current amplitude $|\overline{I}_{inj}(f_i)|$ supplied at all frequencies $[f_{min}, f_{max}]$),
2. Lowest effective injection device current value: $\min|\overline{I}_{inj}(f_i)|$ (constant injection voltage amplitude $|\overline{U}_{inj}(f_i)|$ supplied at all frequencies $[f_{min}, f_{max}]$)
3. Highest effective zero-sequence impedance value: $\max|\overline{Z}_0(f_i)|$
4. Lowest effective zero-sequence admittance value: $\min|\overline{Y}_0(f_i)|$

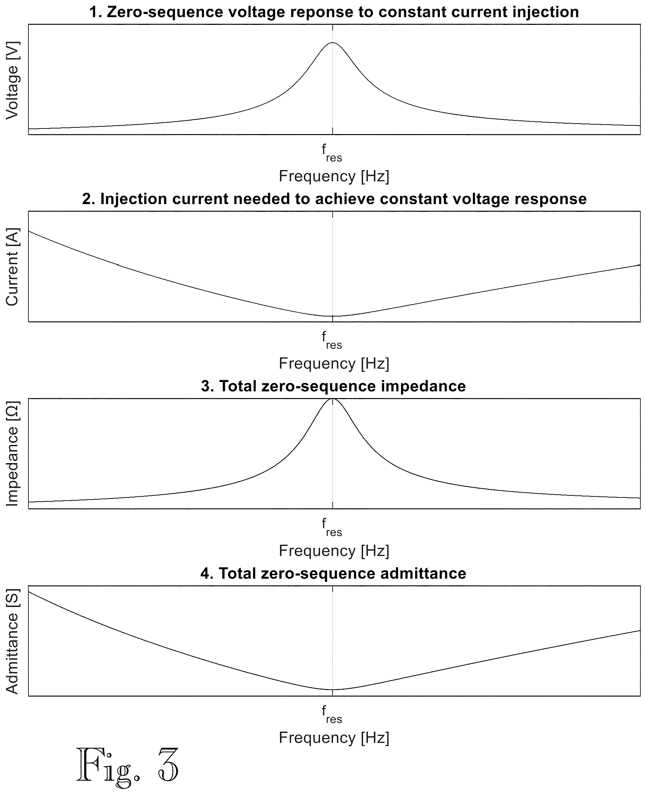

Figure 3 shows an exemplary diagram in which an example of each of the above situations 1-4 is shown. More specifically, in Figure 3 the first diagram shows an example of a zero-sequence voltage response curve to a constant current injection, the second diagram shows an example of an injection current needed to achieve a constant voltage response, the third diagram shows an example of a total zero-sequence impedance response curve, and the fourth diagram shows an example of a total zero-sequence admittance response curve. The resonant frequency can then be found on the basis of the maximum or minimum value of the response curve, which represents the highest response to the current injection.

According to an embodiment, the determination of the resonant frequency, e.g. for previous conditions 3 and 4, can be expressed by a mathematical formula as follows:

$$f_{res} = \arg\max_{f_i \in [f_{min}, f_{max}]} \left|\overline{Z}_0(f_i)\right|$$

$$f_{res} = \arg\min_{f_i \in [f_{min}, f_{max}]} \left|\overline{Y}_0(f_i)\right|$$

And, in terms of $\omega_i = 2\pi f_i$, where $f_i \in [f_{min}, f_{max}]$,

$$\omega_{res} = \arg\max_{\omega_i \in [\omega_{min}, \omega_{max}]} \left|\overline{Z}_0(\omega_i)\right|$$

$$\omega_{res} = \underset{\omega_i \in [\omega_{min}, \omega_{max}]}{\arg \min} \left| \overline{Y}_0(\omega_i) \right|$$

According to an embodiment, $\overline{Z}_0(f_i)$ and/or $\overline{Y}_0(f_i)$ can be determined based on a measured zero-sequence voltage in respect to injection current at the frequency of the current injection when $f_i \# f_s$ (in completely symmetrical networks $f_i = f_s$ is also allowed):

$$\overline{Z}_0(f_i) = \frac{\overline{U}_0(f_i)}{\overline{I}'_{inj}(f_i)}$$

$$\overline{Y}_0(f_i) = \frac{\overline{I}'_{inj}(f_i)}{\overline{U}_0(f_i)}$$

According to an embodiment, for $f_i = f_s$, to determine $\overline{Z}_0(f_s)$ and/or $\overline{Y}_0(f_s)$ the delta calculation can be applied as follows to remove the influence of the natural asymmetry of the electric network:

$$\overline{Z}_0(f_s) = \frac{\Delta \overline{U}_0(f_s)}{\Delta \overline{I}'_{inj}(f_s)} = \frac{\overline{U}_0^2(f_s) - \overline{U}_0^1(f_s)}{\overline{I}'^2_{inj}(f_s) - \overline{I}'^1_{inj}(f_s)}$$

$$\overline{Y}_0(f_s) = \frac{\Delta \overline{I}'_{inj}(f_s)}{\Delta \overline{U}_0(f_s)} = \frac{\overline{I}'^2_{inj}(f_s) - \overline{I}'^1_{inj}(f_s)}{\overline{U}_0^2(f_s) - \overline{U}_0^1(f_s)}$$

where:

$\overline{U}_0^1(f_s)$ and $\overline{U}_0^2(f_s)$ are responses for two different current injection signals $\overline{I}'^1_{inj}(f_s)$ and $\overline{I}'^2_{inj}(f_s)$ for which $\overline{I}'^1_{inj}(f_s) \neq \overline{I}'^2_{inj}(f_s)$ either by amplitude and/or phase angle.

This then may require using two different e.g. sequential current injection cycles at the synchronous frequency of the three-phase electric network, $f_s$, with different amplitude and/or phase angles, for example.

However, using $f_i = f_s$ or frequencies close to it can also be avoided, so that the frequency range may be modified as follows:

$$f_i \in [f_{min}, f_{max}] \setminus f_s$$

or

$$f_i \in [f_{min}, f_{max}] \setminus [f_{s\_min}, f_{s\_max}]$$

where:

$[f_{min}, f_{max}]$ is a total frequency range
$[f_{s\_min}, f_{s\_max}]$ is an excluded frequency range (close to $f_s$) so that:

$$f_{min} < f_{s\_min} < f_s$$

$$f_s < f_{s\_max} < f_{max} .$$

According to an embodiment, the injection current may be measured directly at the output of the current injection source, e.g., from a power auxiliary winding of the arc suppression device where the current signal may be injected. The zero-sequence voltage response however can be measured from various points, thus resulting alternative variants of the zero-sequence impedance and/or admittance. These variants may include a voltage measurement winding of the arc suppression device, power auxiliary winding of the arc suppression device, open delta winding of a voltage transformer(s) or calculated vector sum of the measured phase voltages, for example, each with different advantages.

According to another embodiment, the determining of the resonant frequency of the zero-sequence system of the three-phase electric network could be performed as described in EP 1693679 B1, wherein the frequency spectrum is injected not sequentially but simultaneously. The auxiliary injection signal may be injected in a form of a pulse, wherein the frequency spectrum of the injection pulse may cover a range between a selectable minimum and maximum frequencies substantially without gaps and the resonant frequency of the electric system is contained in the frequency spectrum.

According to an embodiment, the sequentially injected current signals may be multifrequency current signals each multifrequency current signal comprising at least two different frequencies. Accordingly, the determining of the resonant frequency of the zero-sequence system of the three-phase electric network could be implemented as a hybrid method wherein a set of different multifrequency current signals (each with e.g. 2 or more frequency components), or pulse patterns are sequentially injected, so that the sequential and simultaneous injection methods may be combined. In this case, by sequentially injecting selected multifrequency signals or pulse patterns, the resonant frequency can be determined efficiently, with a smaller number of required current injection cycles. These multi-frequency signals may have the following form:

$$
\begin{aligned}
I'_{inj}(t, f_1, f_2, &\ldots, f_n, \theta_1, \theta_2, \ldots, \theta_n) \\
&= \hat{I}'_{inj}(f_1)sin(2\pi f_1 t + \theta_1) \; + \hat{I}'_{inj}(f_2)sin(2\pi f_2 t + \theta_2) \ldots \\
&\quad + \hat{I}'_{inj}(f_n)sin(2\pi f_n t + \theta_n)
\end{aligned}
$$

with $n \geq 2$ number of frequency components. However, adding more frequency components may also increase the power requirement needed to produce such a multifrequency current injection signal.

Generally, e.g. a switching operation or a change in the electric network detuning may be detected or identified when the value of the resonant frequency of the zero-sequence system of the three-phase electric network deviates from a reference value in a predetermined way, e.g. more than a selected tolerance, for example. According to an embodiment, such a reference value may be predetermined and/or determined and stored (updated) for comparison e.g. after every successful tuning procedure of the arc suppression device by any known method in which point the electric network parameters are known. According to an embodiment, the determining whether to initiate the tuning of the arc suppression device of the three-phase electric network comprises comparing the determined resonant frequency of the zero-sequence system of the three-phase electric network with a reference value and determining to initiate the tuning of the arc suppression device of the three-phase electric network in response to the determined resonant frequency of the zero-sequence system of the three-phase electric network deviating from the reference value in a predetermined manner. According to an embodiment, the value of the resonant frequency of the zero-sequence system of the three-phase electric network deviates from the reference value in the predetermined manner if a difference between the value of the resonant frequency of the zero-sequence system of the three-phase electric network and the reference value exceeds a predetermined threshold.

According to an embodiment, the tuning of the arc suppression device of the three-phase electric network may be performed in response to determining to initiate the tuning of the arc suppression device. The tuning of the arc suppression device of the three-phase electric network may be performed in any suitable manner known as such.

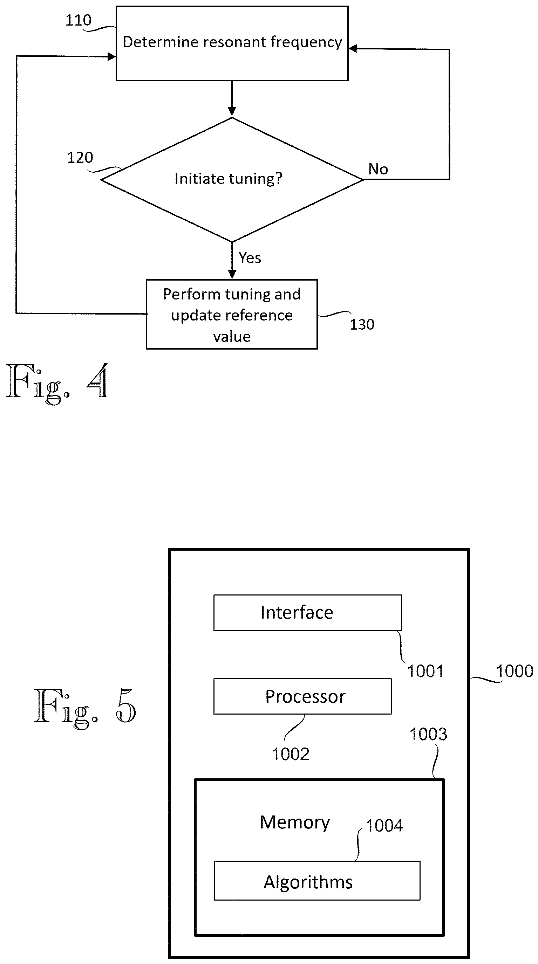

Figure 4 shows a flow diagram according to an embodiment. The resonant frequency of the zero-sequence system of the three-phase electric network is determined in step 110. In step 120, it is determined, based on the determined resonant frequency of the zero-sequence system of the three-phase electric network and a reference value, whether to initiate a tuning of the arc suppression device of the three-phase electric network. If it is determined not to initiate the tuning, the resonant frequency determination 110 may be repeated e.g. essentially immediately or after a predetermined delay. If it is determined to initiate the tuning, the tuning is performed, and the reference value may be updated in step 130. The reference value may be updated to have the value possibly obtained in connection with the tuning of the arc suppression device in step 130, i.e. corresponding to the calculated electric network parameters after a successful tuning operation. Alternatively, the updated reference value may be determined separately e.g. essentially directly after successful coil tuning operation using current injection in a similar manner as in step 110, for example. After step 130, the resonant frequency determination 110 may be repeated e.g. essentially immediately or after a predetermined delay.

The disclosed solution according to the embodiments described herein enables to detect or identify e.g. network switching operations and/or changes in the detuning in various three-phase electric networks, including essentially symmetrical networks. The disclosed solution is robust against network frequency disturbances, high load changes etc.

The disclosed solution may detect changes essentially only in the detuning of the electric network compensation, while changes e.g. in the damping are not detected, which is beneficial if the solution is used to trigger arc suppression device tuning procedure as disclosed.

The first control arrangement 11, the second control arrangement 31, or a combination thereof, and/or any other means for implementing at least part of the functionality according to any one of the embodiments herein may be implemented as one physical unit or as two or more separate physical units that are configured to implement the functionality. Herein the term 'unit' generally refers to a physical or logical entity, such as a physical device or a part thereof or a software routine. Figure 5 is a simplified block diagram illustrating some units for an apparatus (device, equipment) 1000 configured to perform at least some functionality of the first control arrangement 11, the second control arrangement 31, or a combination thereof, or generally any corresponding apparatus. In the illustrated example, the apparatus 1000 comprises one or more interface (IF) entities 1001, such as one or more user interfaces and/or data interfaces, and one or more processing entities 1002 connected to various interface entities 1001 and to one or more memories 1003. The one or more interface entities 1001 may be entities for receiving and transmitting information, such as communication interfaces comprising hardware and/or software for realising communication connectivity according to one or more communication protocols, or for realising data, e.g. measuring data, storing and fetching, and/or for providing user interaction via one or more user interfaces. A processing entity 1002 is capable to perform calculations and configured to implement at least part of functionalities/operations described above, with corresponding algorithms 1004 stored in the memory 1003. The processing entity 1002 may include one or more processors, controllers, control units, micro-controllers, etc. configurable to carry out e.g. embodiments, examples, implementations and/or operations described above. Generally, a processor may be a central processing unit, but the processor entity 1002 may be an additional operation processor or a multicore processor or a microprocessor, for instance. A memory 1003 may be usable for storing a computer program code required for one or more functionalities/operations described above, that is, the algorithms 1004 for implementing the functionality/operations described above. The memory 1003 may also be usable for storing, at least temporarily, other possible information required for one or more functionalities/operations described above. The memory 1003 may comprise a data buffer that may, at least temporarily, store for example measurement data and/or information received as a user input. The apparatus comprising the means for providing any embodiment described herein may be implemented at least partly by means by such apparatus 1000 as exemplified in Figure 5.

Generally, first control arrangement 11, the second control arrangement 31, or a combination thereof, and/or any other means for implementing at least part of the functionality according to any one of the embodiments herein may be implemented at least partly by means of one or more computers or corresponding digital signal processing (DSP) equipment provided with suitable software, for example. Such a computer or digital signal processing equipment preferably comprises at least a working memory (RAM) providing storage area for arithmetical operations, and a central processing unit (CPU), such as a general-purpose digital signal processor. The CPU may comprise a set of registers, an arithmetic logic unit, and a control unit. The CPU control unit is controlled by a sequence of program instructions transferred to the CPU from the RAM. The CPU control unit may contain a number of microinstructions for basic operations. The implementation of microinstructions may vary depending on the CPU design. The program instructions may be coded by a programming language, which may be a high-level programming language, such as C, Java, etc., or a low-level programming language, such as a machine language, or an assembler. The computer may also have an operating system which may provide system services to a computer program written with the program instructions. The computer or other apparatus implementing the various embodiments, or a part thereof, may further comprise suitable input means for receiving e.g. measurement and/or control data, and output means for outputting e.g. control or any other data. It is also possible to use a specific integrated circuit or circuits, such as application-specific integrated circuits (ASIC), digital signal processing devices (DSPD), programmable logic devices (PLD), field-programmable gate arrays (FPGA) and/or discrete electric components and devices for implementing the functionality according to any one of the embodiments.

The various embodiments described herein can be implemented at least partly in existing system elements, such as various arc suppression device(s) or similar device(s), and/or by using separate dedicated elements or devices in a centralized or distributed manner. Present arc suppression devices for electric networks may comprise processors and memory that may be utilized in the functions according to the various embodiments described herein. Generally, many electric devices, such as electric power systems, and components thereof, such as intelligent electronic devices, may comprise processors and memory that may also be utilized in implementing the functionality according to the various embodiments described herein. Thus, at least some modifications and configurations possibly required for implementing an embodiment could be performed as software routines, which may be implemented as added or updated software routines. If at least part of the functionality of any of the embodiments is implemented by software, such software may be provided as a computer program product comprising computer program code which, when run on a computer, causes the computer or corresponding arrangement to perform the functionality according to the embodiments as described herein. Such a computer program code may be stored or generally embodied on a computer readable medium, such as suitable memory, e.g. a flash memory or an optical memory, from which it is loadable to the unit or units executing the program code. In addition, such a computer program code implementing any of the embodiments may be loaded to the unit or units executing the computer program code via a suitable data network, for example, and it may replace or update a possibly existing program code. An embodiment may provide a computer program embodied on any client-readable distribution/data storage medium or memory unit(s) or article(s) of manufacture, comprising program instructions executable by one or more processors/computers, which instructions, when loaded into an apparatus, constitute the control arrangement, or any corresponding unit or an entity providing corresponding functionality, or at least part of the corresponding functionality. Programs, also called program products, including software routines, program snippets constituting "program libraries", applets and macros, can be stored in any medium and may be downloaded into an apparatus. In other words, each or some or one of the possible units/sub-units and/or algorithms for one or more functions/operations described above, for example by means of any of Figures 1 to 5 and any combination thereof, may be an element that comprises one or more arithmetic logic units, a number of special registers and control circuits.

It will be obvious to a person skilled in the art that, as the technology advances, the inventive concept can be implemented in various ways. The invention and its embodiments are not limited to the examples described above but may vary within the scope of the claims.

**Claims**

1. A method for controlling an arc suppression device of a three-phase electric network, the arc suppression device having an adjustable admittance connected between a neutral point of the three-phase electric network and earth, the method comprising:

   a) determining a resonant frequency of a zero-sequence system of the three-phase electric network; and
   b) determining, based on the determined resonant frequency of the zero-sequence system of the three-phase electric network, whether to initiate a tuning of the arc suppression device of the three-phase electric network.

2. A method as claimed in claim 1, wherein the determining whether to initiate the tuning of the arc suppression device of the three-phase electric network comprises comparing the determined resonant frequency of the zero-sequence system of the three-phase electric network with a reference value and determining to initiate the tuning of the arc suppression device of the three-phase electric network in response to the determined resonant frequency of the zero-sequence system of the three-phase electric network deviating from the reference value in a predetermined manner.

3. A method as claimed in claim 1 or 2, wherein the determining of the resonant frequency of the zero-sequence system of the three-phase electric network comprises:

   sequentially injecting current signals of varying frequency or frequencies into the neutral point of the three-phase electric network;
   monitoring a response in the three-phase electric network to the sequential injection of the current signals; and
   determining the resonant frequency of the zero-sequence system of the three-phase electric network on the basis of the monitored response in the three-phase electric network to the sequential injection of the current signals.

4. A method as claimed in claim 3, wherein the sequential injection of the current signals is performed as a frequency sweep, wherein the frequency or frequencies of the sequentially injected current signals are varied between a predetermined minimum frequency and a predetermined maximum frequency.

5. A method as claimed in claim 4, wherein the frequency or frequencies of the sequentially injected current signals are varied between the predetermined minimum frequency and the predetermined maximum frequency in an increasing manner starting from the predetermined minimum frequency or in a decreasing manner starting from the predetermined maximum frequency.

6. A method as claimed in claim 5, wherein the frequency or frequencies of the sequentially injected current signals are varied in a continuous manner or in a discrete manner.

7. A method as claimed in any one of claims 1 to 6, wherein steps a) to b) are repeated essentially continuously or at predetermined intervals.

8. An apparatus for controlling an arc suppression device of a three-phase electric network, the arc suppression device having an adjustable admittance connected between a neutral point of the three-phase electric network and earth, the apparatus comprising:

means configured to determine a resonant frequency of a zero-sequence system of the three-phase electric network; and

means configured to determine, based on the determined resonant frequency of the zero-sequence system of the three-phase electric network, whether to initiate a tuning of the arc suppression device of the three-phase electric network.

9. An apparatus as claimed in claim 8, wherein the means configured to determine whether to initiate the tuning of the arc suppression device of the three-phase electric network are configured to compare the determined resonant frequency of the zero-sequence system of the three-phase electric network with a reference value and determine to initiate the tuning of the arc suppression device of the three-phase electric network in response to the determined resonant frequency of the zero-sequence system of the three-phase electric network deviating from the reference value in a predetermined manner.

10. An apparatus as claimed in claim 8 or 9, wherein the means configured to determine the resonant frequency of the zero-sequence system of the three-phase electric network are configured to:

sequentially inject current signals of varying frequency or frequencies into the neutral point of the three-phase electric network;

monitor a response in the three-phase electric network to the sequential injection of the current signals; and

determine the resonant frequency of the zero-sequence system of the three-phase electric network on the basis of the monitored response in the three-phase electric network to the sequential injection of the current signals.

11. An apparatus as claimed in claim 10, wherein the means configured to determine the resonant frequency of the zero-sequence system of the three-phase electric network are configured to perform the sequential injection of the current signals as a frequency sweep, wherein the frequency or frequencies of the sequentially injected current signals are varied between a predetermined minimum frequency and a predetermined maximum frequency.

12. An apparatus as claimed in claim 11, wherein the frequency or frequencies of the sequentially injected current signals are varied between the predetermined minimum frequency and the predetermined maximum frequency in an increasing manner starting from the predetermined minimum frequency or in a decreasing manner starting from the predetermined maximum frequency.

13. An apparatus as claimed in claim 12, wherein the frequency or frequencies of the sequentially injected current signals are varied in a continuous manner or in a discrete manner.

14. An apparatus as claimed in any one of claims 8 to 13, further comprising means configured to perform the tuning of the arc suppression device of the three-phase electric network in response to determining, by the means configured to determine whether to initiate the tuning of the arc suppression device, to initiate the tuning of the arc suppression device.

15. An arc suppression device for a three-phase electric network, the arc suppression device having an adjustable admittance and being configured to be connected between a neutral point of the three-phase electric network and earth, and comprising an apparatus as claimed in any one of claims 8 to 14.

Fig. 1

EP 4 749 300 A1

Fig. 2

EP 4 749 300 A1

**1. Zero-sequence voltage reponse to constant current injection**

**2. Injection current needed to achieve constant voltage response**

**3. Total zero-sequence impedance**

**4. Total zero-sequence admittance**

Fig. 3

110 Determine resonant frequency

120 Initiate tuning?

No

Yes

Perform tuning and update reference value 130

Fig. 4

Fig. 5

Interface

1001 1000

Processor

1002

1003

Memory 1004

Algorithms

**EP 4 749 300 A1**

| | Europäisches Patentamt |
| --- | --- |
| | European Patent Office |
| | Office européen des brevets |

# EUROPEAN SEARCH REPORT

**Application Number**

EP 24 21 4685

## DOCUMENTS CONSIDERED TO BE RELEVANT

| Category | Citation of document with indication, where appropriate, of relevant passages | Relevant to claim | CLASSIFICATION OF THE APPLICATION (IPC) |
| --- | --- | --- | --- |
| X | WO 2016/029890 A1 (EGE SPOL SR O [CZ]) 3 March 2016 (2016-03-03) * page 7, line 7 - page 8, line 21; figures 1,3 * * page 11, lines 16-23 * * page 15, line 2 - page 16, line 21 * * page 19, lines 4-11 * | 1-15 | INV. G01R31/08 H02H9/08 |
| X | EP 1 693 679 B1 (ADAPTIVE REGELSYSTEME GMBH [AT]) 11 June 2014 (2014-06-11) * paragraphs [0018], [0019], [0016], [0071], [0017] * | 1,2,7-9, 14,15 | |
| X | WO 02/15355 A2 (ADAPTIVE REGELSYSTEME GES M B [AT]; LEIKERMOSER ALBERT [AT]) 21 February 2002 (2002-02-21) * page 3, line 26 - page 4, line 7 * * page 4, line 30 - page 5, line 3 * * page 5, lines 4-29 * | 1,2,7-9, 14,15 | |
| | | | **TECHNICAL FIELDS SEARCHED (IPC)** G01R H02H |

The present search report has been drawn up for all claims

| Place of search | Date of completion of the search | Examiner |
| --- | --- | --- |
| Munich | 30 April 2025 | Palukova, Mila |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 24 21 4685

This annex lists the patent family members relating to the patent documents cited in  the above-mentioned European search report.
The members are as contained in the European Patent Office EDP file on
The European Patent Office is in no way liable for these particulars which are merely given for the purpose of information.

30-04-2025

| Patent document cited in search report | | Publication date | Patent family member(s) | | Publication date |
|---|---|---|---|---|---|
| WO 2016029890 | A1 | 03-03-2016 | CZ | 308721 B6 | 24-03-2021 |
| | | | WO | 2016029890 A1 | 03-03-2016 |
| EP 1693679 | B1 | 11-06-2014 | EP | 1693679 A1 | 23-08-2006 |
| | | | EP | 2808688 A1 | 03-12-2014 |
| WO 0215355 | A2 | 21-02-2002 | AT | 411937 B | 26-07-2004 |
| | | | AU | 1212902 A | 25-02-2002 |
| | | | EP | 1307753 A2 | 07-05-2003 |
| | | | HU | 225927 B1 | 28-01-2008 |
| | | | WO | 0215355 A2 | 21-02-2002 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 1537371 A
- EP 1693679 B1